# FASCICULE DE BREVET EUROPEEN

(11) **EP 3 865 954 B1**
(45) Date de publication et mention de la délivrance du brevet: **13.08.2025**
(21) Numéro de dépôt: 20156902.7
(22) Date de dépôt: 12.02.2020
(51) Int. Cl.: G04B 17/04, G04B 17/06, G04B 31/06

(54) **PROCEDE DE FABRICATION D'UN DISPOSITIF A LAMES FLEXIBLES MONOBLOC EN SILICIUM, POUR L'HORLOGERIE**
HERSTELLUNGSVERFAHREN EINER MONOBLOCK-VORRICHTUNG MIT FEDERZUNGEN AUS SILIZIUM, FÜR UHRWERK
METHOD FOR MANUFACTURING A DEVICE WITH FLEXIBLE SINGLE-PIECE SILICON SHEETS, FOR TIMEPIECES

(43) Date de publication de la demande: 18.08.2021
(73) Titulaire: Nivarox-FAR S.A., 2400 Le Locle (CH)
(72) Inventeur: CUSIN, Pierre, 1423 Villars-Burquin (CH); GANDELHMAN, Alex, 2013 Colombier Neuchâtel (CH)
(74) Mandataire: ICB SA

(56) Documents cités:
- EP-A1- 3 326 963
- EP-A2- 3 435 172
- CH-A2- 703 464

## Description

### Domaine de l'invention

L'invention se rapporte à un procédé de fabrication d'un dispositif à lames flexibles monobloc en silicium, notamment pour l'horlogerie, par exemple un pivot à lames croisées utilisé comme compensateur coopérant avec un balancier d'inertie connu pour former un résonateur comportant une fréquence prédéterminée.

### Arrière-plan de l'invention

Les oscillateurs basés sur des lames flexibles sont assez communément formés en silicium et bénéficient ainsi des performances en terme de micro-usinage de ce matériau (DRIE). Une catégorie particulière de ces oscillateurs est celle des pivots dits « à lames croisées », pour lesquels deux lames sont formées dans deux couches distinctes de deux plans sensiblement parallèles et se croisent. Ces pivots permettent de faire osciller en rotation un élément, par exemple un balancier de mécanisme oscillateur ou une ancre de mécanisme d'échappement.

La fabrication de tels pivots peut se faire de manières différentes. Une première méthode consiste à fabriquer les deux lames séparément et les assembler en ménageant un espace entre les lames. Un tel procédé permet de choisir un espace suffisant entre les lames pour éviter qu'elles ne s'entrechoquent. Cependant, la disposition des lames l'une par rapport à l'autre n'est pas toujours précise, ce qui diminue les performances du pivot en terme de chronométrie.

Une deuxième méthode consiste à fabriquer un pivot monobloc en usinant deux couches d'un wafer de silicium de type SOI. Cette méthode est très efficace pour disposer les lames l'une par rapport à l'autre, mais elle ne permet pas d'avoir un espace de sécurité suffisamment large entre les lames, pour éviter l'entrechoquement durant le fonctionnement du pivot. En effet, l'espace dépend de l'épaisseur d'oxyde liant les deux couches du wafer SOI, l'épaisseur étant bien inférieure à l'espace de sécurité requis. Un exemple d'application de cette deuxième méthode est décrit dans le document EP3326963A1.

### Résumé de l'invention

Le but de la présente invention est de pallier tout ou partie des inconvénients cités précédemment en proposant un procédé de fabrication d'un dispositif à lames flexibles monobloc en silicium, dont l'espace de sécurité entre les plans des lames est suffisant, en particulier en largeur.

A cet effet, l'invention se rapporte à un procédé de fabrication d'un dispositif à lames flexibles monobloc en silicium, par exemple un pivot à lames croisées, le procédé étant défini dans la revendication 1.

On obtient ainsi un dispositif à lames flexibles, par exemple un pivot à lames croisées, avec un espace de sécurité suffisant entre lames pour éviter une collision des lames pendant le fonctionnement du dispositif. En effet, lorsqu'une couche d'oxyde de silicium croît sur du silicium, une sous-couche de silicium est elle-même oxydée, de sorte que lorsque la couche d'oxyde de silicium est supprimée par gravure, la sous-couche de silicium a été enlevée de la masse de silicium du départ. Le volume de silicium final est donc réduit par rapport au volume de silicium de départ.

Ainsi, grâce à cet effet, on peut agrandir l'espace entre les lames en répétant les opérations de croissance d'oxyde de silicium, puis de suppression de la couche d'oxyde de silicium. A chaque suppression de couche d'oxyde de silicium, l'espace s'élargit.

Selon un mode de réalisation particulier de l'invention, le procédé comprend les étapes suivantes :
- faire croître une deuxième couche d'oxyde de silicium à la surface d'au moins une des lames bordant l'espace, la deuxième couche d'oxyde de silicium étant formée à partir d'une deuxième sous-couche de silicium de la ou des lames,
- éliminer la deuxième couche d'oxyde de silicium pour agrandir davantage l'espace entre les deux lames.

Selon un mode de réalisation particulier de l'invention, on répète plusieurs fois les étapes successives de croissance de couches d'oxyde de silicium et d'élimination de la couche pour agrandir l'espace entre les deux lames pour atteindre une largeur souhaitée.

Selon un mode de réalisation particulier de l'invention, l'ébauche de dispositif comprend des lames croisées jointes au croisement par une jointure, la jointure étant formée au moins en partie d'oxyde de silicium, le procédé comprenant une étape d'élimination de l'oxyde de silicium de la jointure entre les lames pour les séparer en créant ledit espace entre les lames.

Selon un mode de réalisation particulier de l'invention, chaque couche d'oxyde de silicium est éliminée par gravure au moyen de fluorure d'hydrogène en phase vapeur.

Selon un mode de réalisation particulier de l'invention, la croissance d'oxyde de silicium est effectuée par oxydation thermique humide ou sèche du silicium.

Selon un mode de réalisation particulier de l'invention, l'ébauche de dispositif est effectuée par gravure ionique réactive profonde de type DRIE, par exemple réalisé à l'aide d'un gravage chimique.

Selon un mode de réalisation particulier de l'invention, chaque croissance et élimination de couche d'oxyde de silicium permet d'enlever une sous couche de silicium d'au moins 0,10 µm d'épaisseur sur une lame, de préférence d'au moins 0,40µm.

Selon un mode de réalisation particulier de l'invention, le procédé comprend une étape supplémentaire de croissance d'une couche d'oxyde supplémentaire sur le dispositif pour ajuster thermiquement la raideur du dispositif en fonction de la température, notamment pour compenser en température un oscillateur formé d'un ensemble pivot balancier, et/ou pour renforcer le dispositif.

Selon un mode de réalisation particulier de l'invention, le procédé comprend une étape supplémentaire de dépôt d'une couche électriquement conductrice pour éviter les problèmes liés à l'accumulation de charges électrostatiques ou d'absorption d'humidité.

Selon un mode de réalisation particulier de l'invention, le procédé comprend une étape de détermination de la raideur initiale du dispositif et de calcul de ses dimensions pour obtenir un pivot d'une raideur finale souhaitée.

Selon un mode de réalisation particulier de l'invention, l'étape de formation de l'ébauche de dispositif comprend les sous-étapes suivantes :
- se munir d'un wafer SOI comprenant successivement une première couche de silicium, une couche de liaison en oxyde de silicium, et une deuxième couche de silicium ;
- faire croître une couche d'oxyde de silicium à la surface du wafer ;
- graver la couche d'oxyde de silicium d'un premier côté du wafer à travers un masque formé précédemment ;
- réaliser un gravage ionique réactif profond pour former au moins une première lame du dispositif à lames flexibles monobloc en silicium ;
- graver la couche d'oxyde de silicium d'un deuxième côté du wafer à travers un second masque formé précédemment, de préférence aligné par rapport aux motifs formés sur le premier côté du wafer,
- réaliser un gravage ionique réactif profond pour former au moins une deuxième lame du dispositif à lames flexibles monobloc en silicium.

Selon un mode de réalisation particulier de l'invention, l'espace minimal obtenu entre les lames après les étapes du procédé a une largeur supérieure à 10 µm, de préférence supérieure à 15 µm.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 illustre une vue de dessus d'un pivot à lames croisées selon l'invention,
- la figure 2 illustre une vue en perspective d'un pivot à lames croisées selon l'invention,
- la figure 3 illustre une vue de côté d'un pivot à lames croisées obtenu grâce au procédé selon l'invention,
- la figure 4 est un schéma synoptique illustrant les différentes étapes d'un procédé de fabrication d'un pivot flexible à lames croisées monobloc en silicium selon l'invention,
- la figure 5 illustre une vue en coupe d'un wafer permettant le fabrication du pivot,
- la figure 6 illustre une vue de côté d'un pivot à lames croisées obtenu après la première étape du procédé selon l'invention,
- la figure 7 illustre une vue de côté d'un pivot à lames croisées obtenu après la deuxième étape du procédé selon l'invention,
- la figure 8 illustre une vue de côté d'un pivot à lames croisées obtenu après la troisième étape du procédé selon l'invention,
- la figure 9 illustre une vue de côté d'un pivot à lames croisées obtenu après la quatrième étape du procédé selon l'invention,
- la figure 10 illustre une vue de côté d'un pivot à lames croisées obtenu après la cinquième étape du procédé selon l'invention,
- la figure 11 illustre une vue de côté d'un pivot à lames croisées obtenu après la sixième étape du procédé selon l'invention.

### Description détaillée des modes de réalisation préférés

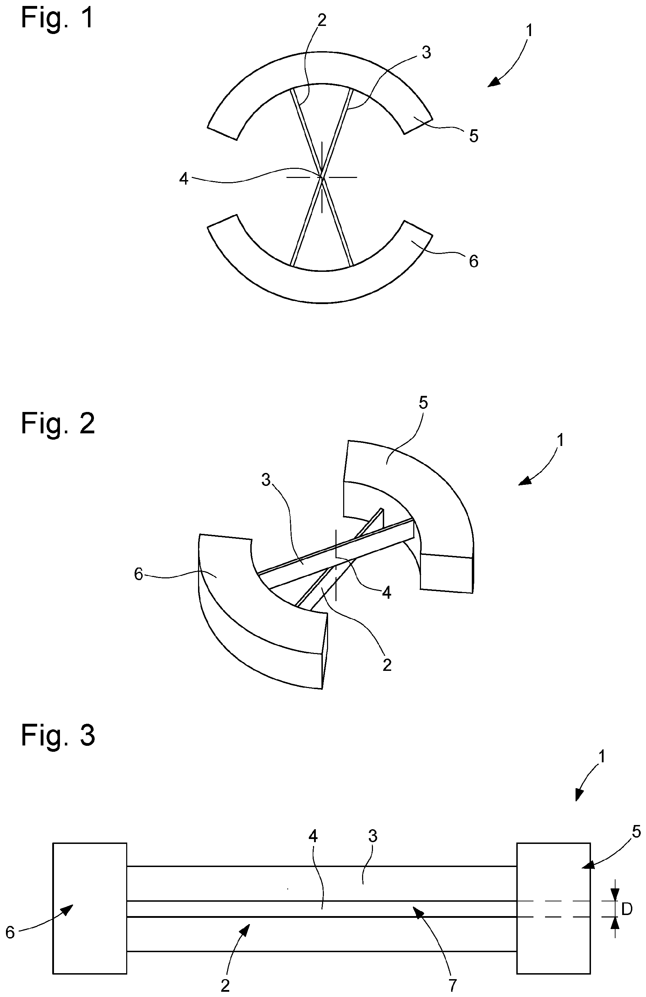

L'invention se rapporte à un dispositif à lames flexibles monobloc en silicium, en particulier un pivot à lames croisées 1 visible aux figures 1 à 3, ainsi que son procédé de fabrication permettant d'obtenir un pivot monobloc dont l'espace entre les lames est suffisamment large pour éviter un entrechoquement des lames en cours d'utilisation.

Un tel pivot 1 comporte un premier 5 et un deuxième élément 6, ainsi que deux lames croisées 2, 3, les deux lames croisées 2, 3 reliant les deux éléments 5, 6 l'un à l'autre. Les deux lames 2, 3 sont reliées à chaque élément 5, 6, le pivot 1 étant monobloc. Le premier élément 5 est par exemple un support de fixation du pivot au mouvement d'horlogerie, et le deuxième élément 6 est un composant nécessitant d'être pivoté. Un tel composant est par exemple une ancre d'échappement, un balancier ou un support de balancier de mouvement d'horlogerie. Les deux lames 2, 3 se croisent entre les deux éléments 5, 6 à un croisement 4. Grâce aux lames flexibles 2, 3, le deuxième élément 6 est mobile par rapport au premier élément 5 autour d'un axe virtuel. Ainsi, le premier élément 5 est fixe sur le mouvement d'horlogerie, tandis que le deuxième élément 6 effectue un mouvement de va-et-vient périodique. Les lames 2, 3 se courbent latéralement, pour permettre le déplacement du deuxième élément 6 dans un sens, puis dans l'autre sens.

Les lames 2, 3 sont agencées dans deux plans parallèles séparés d'un espace minimal 7 pour éviter un entrechoquement des lames 2, 3 pendant le fonctionnement du pivot flexible, notamment en cas de déformation parasite.

L'utilisation d'un matériau, par exemple à base de silicium, pour la fabrication d'un pivot 1 offre l'avantage d'être précis par les méthodes de gravage existantes et de posséder de bonnes propriétés mécaniques et chimiques en étant notamment peu ou pas sensible aux champs magnétiques.

Préférentiellement, le matériau à base de silicium utilisé peut être du silicium monocristallin quelle que soit son orientation cristalline, du silicium monocristallin dopé quelle que soit son orientation cristalline, du silicium amorphe, du silicium poreux, du silicium polycristallin, du nitrure de silicium, du carbure de silicium, du quartz quelle que soit son orientation cristalline ou de l'oxyde de silicium.

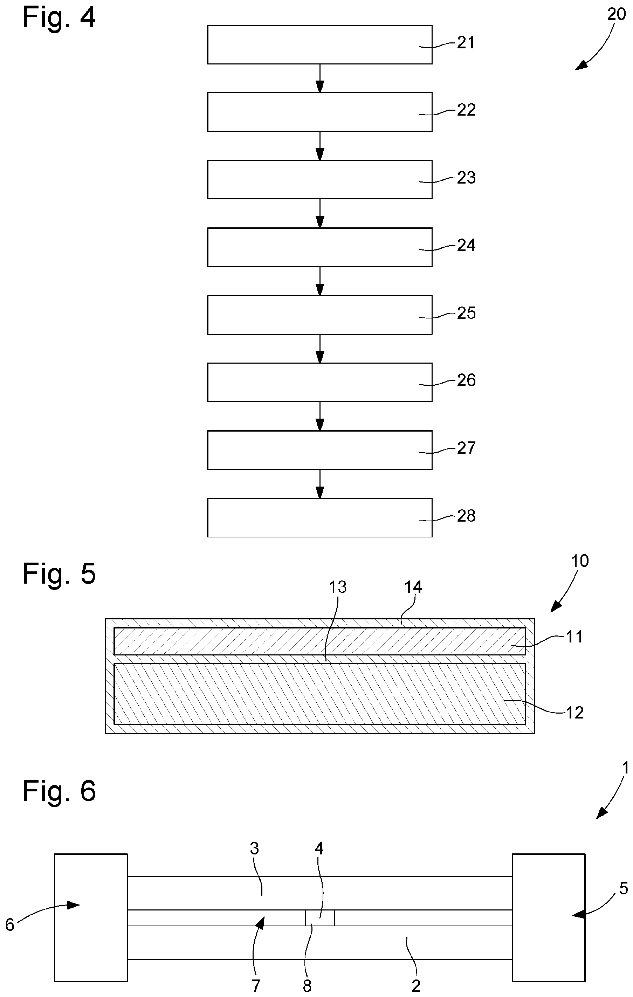

Ainsi, l'invention se rapporte à un procédé de fabrication 20 d'un pivot 1 à lames flexibles 2, 3 croisées en silicium visible à la figure 4.

Le procédé 20 comporte une première étape 21 de fabrication d'une ébauche de pivot en silicium. Cette étape 21 consiste à se munir de wafers SOI 10, représenté à la figure 5, qui est composé de deux couches de silicium 11 et 12, liées l'une à l'autre par une première couche d'oxyde de silicium 13. Les couches de silicium 11, 12 sont formées dans une plaque de silicium monocristallin (dont les orientations principales peuvent être variées). Chaque couche de silicium 11, 12 permettra de fabriquer une lame différente du pivot 1 à lames croisées 2, 3. Ainsi, les lames 2, 3 sont agencées sur deux niveaux différents. La première couche d'oxyde 13 permet de lier intimement les deux couches de silicium 11 et 12. En outre, elle va également servir de couche d'arrêt lors d'opérations ultérieures.

Plusieurs ébauches de pivots peuvent être formées dans le même wafer.

Ensuite, on fait croître à la surface des couches de silicium 11, 12 une deuxième couche d'oxyde de silicium 14, en exposant le ou les wafers à une atmosphère oxydante à haute température. La couche d'oxyde de silicium 14 varie selon l'épaisseur de la couche de silicium 11, 12 à structurer. Elle se situe typiquement entre 1 et 4µm.

Puis, on va définir, par exemple dans une résine positive, les motifs que l'on souhaite réaliser par la suite dans le wafer 10 en silicium à l'aide d'un masque. Le motif comprend au moins une lame du pivot. Les deux lames d'un même pivot sont réalisées chacune sur l'une des deux couches de silicium distinctes 11, 12. On réalise chaque lame l'une après l'autre.

Cette étape 21 comprend les opérations suivantes :
- la résine est déposée, par exemple à la tournette, en une couche très mince d'épaisseur comprise entre 1 et 2µm,
- une fois séchée, cette résine, aux propriétés photolithographiques, est exposée à travers un masque photolithographique (plaque transparente recouverte d'une couche de chrome, elle-même représentant les motifs souhaités) à l'aide d'une source lumineuse ;
- dans le cas précis d'une résine positive, les zones exposées de la résine sont ensuite éliminées au moyen d'un solvant, révélant alors la première couche d'oxyde 13. En l'occurrence, les zones toujours recouvertes de résine définissent les zones que l'on ne souhaite pas voir attaquées dans l'opération ultérieure de gravage ionique réactif profond (également connu sous l'abréviation « D.R.I.E. ») du silicium.

On exploite alors les zones exposées ou au contraire recouvertes de résine. Un premier processus de gravure permet de transférer dans l'oxyde de silicium 14 préalablement crû, les motifs définis dans la résine aux étapes précédentes. Toujours dans une optique de répétabilité du processus de fabrication, l'oxyde de silicium est structuré par une gravure sèche par plasma, directionnelle et reproduisant la qualité des flancs de la résine servant de masque pour cette opération.

On peut également utiliser des masques directement sur le wafer, qui sont appelés hard-mask, tels les masques en oxyde de silicium, nitrures de silicium ou métal. Ces masques sont préalablement structurés avec le motif adéquate et peuvent comprendre de la résine ou non lors de leur utilisation.

Une fois l'oxyde de silicium gravé dans les zones ouvertes de la résine, la surface de silicium de la première couche supérieure 11 est alors exposée et prête pour une gravure DRIE. La résine peut être conservée ou non selon qu'on souhaite employer la résine comme masque lors de la gravure DRIE.

Le silicium exposé et non protégé par l'oxyde de silicium est gravé selon une direction perpendiculaire à la surface du wafer (gravure anisotrope DRIE Bosch^{®}). Les motifs de lame formés d'abord dans la résine, puis dans l'oxyde de silicium, sont "projetés" dans l'épaisseur de la couche 11.

Lorsque la gravure débouche sur la première couche d'oxyde de silicium 13 liant les deux couches de silicium 11 et 12, la gravure s'arrête. En effet, à l'instar de l'oxyde de silicium servant de masque lors du processus Bosch^{®} et résistant à la gravure elle-même, la couche d'oxyde enterrée 13, de même nature, y résiste également.

La première couche de silicium 11 est alors structurée dans toute son épaisseur par les motifs définis représentant au moins une première lame de l'ébauche de pivot à fabriquer, maintenant révélée par cette gravure DRIE. On pourrait aussi utiliser un gravage chimique dans un même matériau à base de silicium.

Les lames restent solidaires de la deuxième couche de silicium 12 à laquelle ils sont liés par la première couche d'oxyde de silicium enterrée 13.

On effectue les mêmes opérations de photolithographie sur la deuxième couche de silicium 12, afin de former l'autre lame du pivot à lames croisées. Pour ce faire le wafer 10 est retourné, la résine y est déposée, puis exposée à travers un masque, afin de structurer la deuxième couche de silicium 12, de manière similaire à la première couche 11.

Il existe d'autres variantes de réalisation pour graver le wafer, qui peuvent bien-sûr être utilisées pour ce procédé, que cela soit avec des masques en résine ou des masques durs, dits hard-mask.

Le premier et le deuxième élément 5, 6 du pivot 1 sont, de préférence, formés également pendant la fabrication des lames 2, 3 sur chaque couche de silicium 11, 12 du wafer 10.

A ce stade les deux lames 2, 3 sont jointes l'une à l'autre au croisement 4 des lames 2, 3, de façon à former une jointure 8. La jointure 8 comporte au moins en partie de l'oxyde de silicium issue de la couche d'oxyde de silicium 13 reliant la première et la deuxième couche de silicium 11, 12. De préférence, la jointure 8 est formé en totalité d'oxyde de silicium. L'ébauche de pivot 1 est représentée sur la figure 6. Les lames 2, 3 sont agencées dans deux plans sensiblement parallèles différents, les lames 2, 3 étant jointes entre les deux plans par la jointure 8.

Une deuxième étape 22 du procédé 20 consiste à éliminer l'oxyde de silicium à la jointure 8 des lames 2, 3 pour les séparer en créant un espace 7 entre les lames 2, 3. La couche d'oxyde de silicium 13 est alors gravées au moyen de fluorure d'hydrogène en phase vapeur.

Ainsi, on obtient deux lames 2, 3 séparées par un espace 7 permettant le mouvement des lames l'une par rapport à l'autre. L'espace 7 obtenu a une largeur D correspondant à l'épaisseur de la couche d'oxyde de la jointure, et donc de la couche d'oxyde du wafer.

Cependant, cette épaisseur n'est pas assez importante pour éviter le risque d'entrechoquement des lames 2, 3 lors du fonctionnement du pivot 1. En effet, la première couche d'oxyde de silicium 13 est trop mince pour que les lames 2, 3 soient suffisamment écartées

Le procédé 20 se poursuit avec une séquence destinée à retirer de la matière des lames jusqu'aux dimensions nécessaires en vue d'obtenir un espace 7 de largeur D suffisante, ainsi qu'une raideur de lame adéquate. A cette fin, l'épaisseur des lames 2, 3 est diminuée lors des étapes suivantes.

Pour augmenter la largeur D de l'espace 7 entre les lames 2, 3, une troisième étape 23 consiste à faire croître une première couche d'oxyde de silicium 15 à la surface des lames 2, 3 bordant l'espace 7. La première couche d'oxyde de silicium 15 est formée en partie à partir d'une sous-couche de silicium formant le pivot 1. En effet, lors de la croissance de l'oxyde de silicium sur du silicium, une sous-couche de silicium sur la quelle croît l'oxyde de silicium est elle-même oxydée. Ainsi, l'oxyde de silicium croît aux dépens du silicium sur lequel il croît. Autrement dit, non seulement l'oxyde de silicium croît sur le silicium, mais il croît également dans le silicium.

Une telle phase peut, par exemple, être obtenue par oxydation thermique. Une telle oxydation thermique peut, par exemple, être réalisée entre 800 et 1200 °C sous atmosphère oxydante à l'aide de vapeur d'eau ou de gaz de dioxygène permettant de former de l'oxyde de silicium sur les lames. Lors de cette étape 23, on exploite le fait que l'oxyde de silicium croît de façon régulière, la vitesse d'oxydation et l'épaisseur qui en résulte sont parfaitement maitrisées par l'homme du métier, ce qui permet d'assurer l'uniformité de la couche d'oxyde.

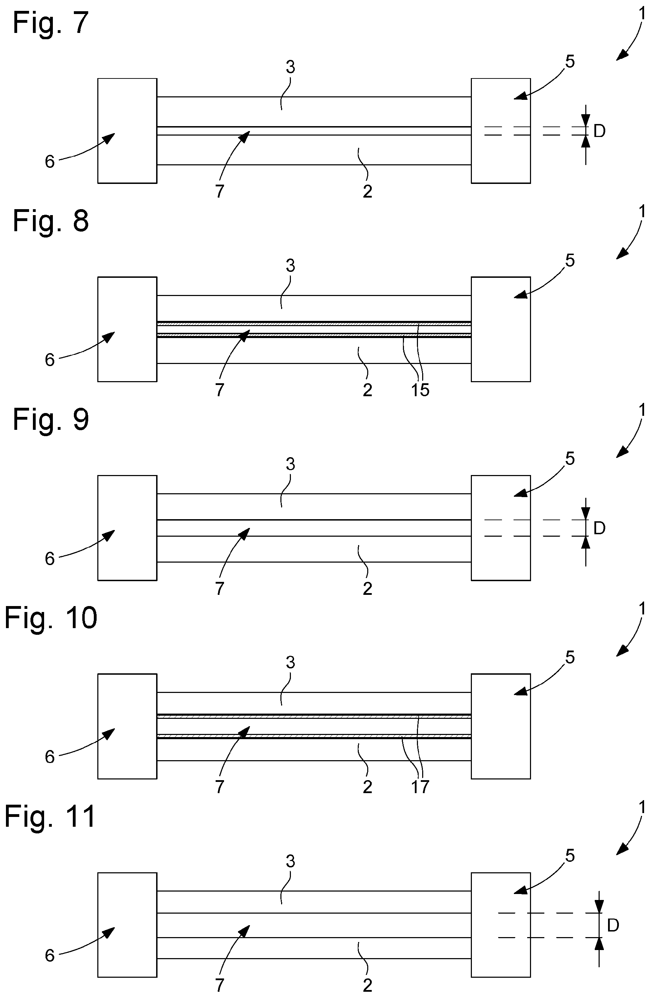

Dans une quatrième étape 24, on élimine la première couche d'oxyde de silicium 15 de chaque lame 2, 3, pour obtenir le pivot 1 représenté sur la figure 9. La sous-couche de silicium étant oxydée, elle est également supprimée. Ainsi, on agrandit l'espace 7 entre les deux lames 2, 3. Une telle élimination est obtenue par gravure chimique. Une telle gravure chimique peut être réalisée, par exemple, au moyen d'une solution à base d'acide fluorhydrique en phase vapeur, qui permet de retirer l'oxyde de silicium.

De préférence, on répète plusieurs fois les paires d'étapes successives de croissance de couches d'oxyde de silicium et d'élimination de la couche d'oxyde. Ainsi, on peut agrandir la largeur D de l'espace 7 entre les deux lames 2, 3 pour atteindre une largeur d'espace souhaitée.

Par exemple, tel que représenté sur la figure 10, une cinquième étape 25 consiste à faire croître une deuxième couche d'oxyde de silicium 17 à la surface des lames 2, 3 de part et d'autre de l'espace, la deuxième couche d'oxyde de silicium 17 étant formée en partie à partir d'une deuxième sous-couche de silicium des lames 2, 3. Puis, en sixième étape 26, on élimine la deuxième couche d'oxyde de silicium 17 de chaque lame 2, 3 pour agrandir davantage l'espace 7 entre les deux lames 2, 3.

Chaque croissance et élimination de couche d'oxyde de silicium permet, par exemple, d'enlever une sous couche de silicium d'au moins 0,10 µm d'épaisseur sur chaque lame 2, 3, de préférence supérieur à 0,40µm. La largeur D minimale souhaitée de l'espace 7 entre les lames 2,3 après les étapes du procédé est, par exemple, supérieur à 10 µm, de préférence supérieur à 15 µm. Néanmoins, la largeur est librement ajustable entre une valeur correspondant à l'épaisseur de la couche d'oxyde initiale liant les deux couches de silicium et une valeur supérieure pouvant aller au-delà de 15µm, la valeur supérieure étant limitée par le nombre d'opération que l'on souhaite effectuer.

La couche d'oxyde de silicium 13 du wafer 10 au départ a par exemple une épaisseur de 2 µm, ce qui définit l'espace initial entre les lames 2, 3 après la suppression de la jointure 8. Ainsi, pour obtenir un espace d'au moins 10 µm, on effectue en série une pluralité de paires d'étapes de croissance et d'élimination d'oxyde de silicium. Pour réduire le nombre d'opérations, on peut allonger le temps d'oxydation des lames, de sorte qu'on enlève une sous-couche de silicium plus épaisse. De préférence, on effectue des étapes de croissance plus courte au début et de plus en plus longue par la suite.

Le procédé peut comporter en outre une étape supplémentaire 27 destinée à déterminer la raideur initiale des lames flexibles, notamment pour pouvoir modifier les dimensions et obtenir de caractéristiques physiques spécifiques recherchées.

Enfin, une fois le pivot 1 aux bonnes dimensions, une autre étape optionnelle supplémentaire 28 peut consister à oxyder à nouveau le pivot 1 pour le revêtir d'une couche de dioxyde de silicium afin de former un pivot 1 qui est thermo-compensé et/ou pour renforcer le pivot. Dans le cas d'un oscillateur, cette dernière oxydation permet d'ajuster à la fois les performances mécanique (raideur) et thermique (compensation en température) du futur pivot 1.

Dans une autre étape optionnelle supplémentaire, non représentée sur les figures, on dépose une couche électriquement conductrice sur le pivot pour éviter les problèmes liés à l'accumulation de charges électrostatiques ou d'absorption d'humidité. A cette fin, on dépose d'abord une couche d'oxyde sur le pivot 1, puis on dépose la couche électriquement conductrice par un dépôt de type PVD. La couche électriquement conductrice comprend par exemple du chrome, du nickel, du cuivre, du titane, du zirconium, du nickel-phosphore ou du titane-tungstène.

Bien entendu, la présente invention ne se limite pas à l'exemple illustré mais est susceptible de diverses variantes et modifications qui apparaîtront à l'homme de l'art, selon l'étendue définie par les revendications. Ainsi, il est possible de réaliser d'autres types de dispositifs à lames flexibles monobloc en silicium, le dispositif ayant par exemple des lames non croisées, et/ou qui servent à un mouvement en translation au lieu d'un mouvement de rotation.

## Revendications

1. Procédé (20) de fabrication d'un dispositif horloger (1) à lames flexibles (2, 3) monobloc en silicium, par exemple un pivot à lames croisées, comportant les étapes suivantes :
- former (21) une ébauche de dispositif horloger (1) monobloc en silicium à partir d'un wafer de type SOI, le dispositif horloger (1) comportant deux lames flexibles (2, 3) formées chacune dans une couche différente du wafer SOI, les lames (2, 3) étant agencées dans deux plans sensiblement parallèles différents, les lames (2, 3) étant séparées par un espace (7),
le procédé étant **caractérisé en ce qu'**il comporte également les étapes suivantes :
- faire croître (23) une première couche d'oxyde de silicium (15) à la surface d'au moins une des lames (2, 3) bordant l'espace (7), la première couche d'oxyde de silicium (15) étant formée à partir d'une première sous-couche de silicium de la ou des lames (2, 3),
- éliminer (24) la première couche d'oxyde de silicium (15) pour agrandir l'espace (7) entre les deux lames (2, 3).

2. Procédé de fabrication selon la revendication 1, **caractérisé en ce qu'**il comprend les étapes suivantes :
- faire croître (25) une deuxième couche d'oxyde de silicium (17) à la surface d'au moins une des lames (2, 3) bordant l'espace (7), la deuxième couche d'oxyde de silicium (17) étant formée à partir d'une deuxième sous-couche de silicium de la ou des lames (2, 3),
- éliminer (26) la deuxième couche d'oxyde de silicium (17) pour agrandir davantage l'espace entre les deux lames (2, 3).

3. Procédé de fabrication selon la revendication 1 ou 2, **caractérisé en ce que** l'on répète plusieurs fois les étapes successives de croissance (23, 25) de couches d'oxyde de silicium (15, 17) et d'élimination (24, 26) de la couche (15, 17) pour agrandir l'espace (7) entre les deux lames (2, 3) pour atteindre une largeur (D) souhaitée.

4. Procédé de fabrication selon l'une, quelconque, des revendications précédentes, **caractérisé en ce que** l'ébauche de dispositif horloger (1) comprend des lames (2, 3) croisées jointes au croisement (4) par une jointure (8), la jointure (8) étant formée au moins en partie d'oxyde de silicium, le procédé comprenant une étape d'élimination (22) de l'oxyde de silicium de la jointure (8) entre les lames (2, 3) pour les séparer en créant ledit espace (7) entre les lames (2, 3).

5. Procédé de fabrication selon l'une, quelconque, des revendications précédentes, **caractérisé en ce que** chaque couche d'oxyde de silicium (13, 14, 15, 17) est éliminée par gravure au moyen de fluorure d'hydrogène en phase vapeur.

6. Procédé de fabrication selon l'une, quelconque, des revendications précédentes, **caractérisé en ce que** la croissance (23, 25) d'oxyde de silicium est effectuée par oxydation thermique humide ou sèche du silicium.

7. Procédé de fabrication selon l'une, quelconque, des revendications précédentes, **caractérisé en ce que** l'ébauche de dispositif horloger (1) est effectuée par gravure ionique réactive profonde de type DRIE.

8. Procédé de fabrication selon l'une, quelconque, des revendications précédentes, **caractérisé en ce que** chaque croissance (23, 25) et élimination (22, 24) de couche d'oxyde de silicium (15, 17) permet d'enlever une sous couche de silicium d'au moins 0, 10 µm d'épaisseur sur une lame (2, 3), de préférence d'au moins 0,40µm.

9. Procédé de fabrication selon l'une, quelconque, des revendications précédentes, **caractérisé en ce qu'**il comprend une étape supplémentaire (27) de croissance d'une couche d'oxyde supplémentaire sur le dispositif horloger (1) pour ajuster thermiquement la raideur du dispositif horloger en fonction de la température, notamment pour compenser en température un oscillateur formé d'un ensemble pivot balancier, et/ou pour renforcer le dispositif horloger.

10. Procédé de fabrication selon l'une, quelconque, des revendications précédentes, **caractérisé en ce qu'**il comprend une étape (28) de détermination de la raideur initiale du pivot (1) et de calcul de ses dimensions pour obtenir un dispositif horloger (1) d'une raideur finale souhaitée.

11. Procédé de fabrication selon l'une, quelconque, des revendications précédentes, **caractérisé en ce qu'**il comprend une étape supplémentaire de dépôt d'une couche électriquement conductrice.

12. Procédé de fabrication selon l'une, quelconque, des revendications précédentes, **caractérisé en ce que** l'étape de formation (21) de l'ébauche de dispositif horloger (1) comprend les sous-étapes suivantes :
- se munir d'un wafer SOI (10) comprenant successivement une première couche de silicium (11), une couche de liaison (13) en oxyde de silicium, et une deuxième couche de silicium (12);
- faire croître une couche d'oxyde de silicium (14) à la surface du wafer (10) ;
- graver la couche d'oxyde de silicium (14) d'un premier côté du wafer (10) à travers un masque ;
- réaliser un gravage ionique réactif profond pour former au moins une première lame (2) du dispositif horloger (1) à lames flexibles monobloc en silicium ;
- graver la couche d'oxyde de silicium (14) d'un deuxième côté du wafer (10) à travers un second masque formé précédemment, de préférence aligné par rapport aux motifs formés sur le premier côté du wafer,
- réaliser un gravage ionique réactif profond pour former au moins une deuxième lame (3) du dispositif horloger (1) à lames flexibles monobloc en silicium.

13. Procédé de fabrication selon l'une, quelconque, des revendications précédentes, **caractérisé en ce que** l'espace (7) minimal obtenu entre les lames (2, 3) après les étapes du procédé a une largeur (D) supérieure à 10 µm, de préférence supérieur à 15 µm.

## Patentansprüche

1. Verfahren (20) zur Herstellung eines Uhrwerks (1) mit flexiblen, einteiligen Lamellen (2, 3) aus Silizium, z. B. eine Achse aus gekreuzten Lamellen, umfassend die folgenden Schritte:
- Bilden (21) eines Rohwerks eines einteiligen Uhrwerks (1) aus Silizium aus einem Wafer vom Typ SOI, wobei das Uhrwerk (1) zwei flexible Lamellen (2, 3) umfasst, die jeweils in einer unterschiedlichen Schicht des SOI-Wafers gebildet sind, wobei die Lamellen (2, 3) in zwei im Wesentlichen parallel verlaufenden Ebenen angeordnet sind, und die Lamellen (2, 3) durch einen Abstand (7) getrennt sind, wobei das Verfahren **dadurch gekennzeichnet ist, dass** es auch die folgenden Schritte umfasst:
- Wachsen lassen (23) einer erste Schicht Siliziumoxid (15) auf der Oberfläche mindestens einer der am Rand des Bereichs angeordneten Lamellen (2, 3) (7), wobei die erste Schicht Siliziumoxid (15) aus einer ersten Unterschicht Silizium der Lamelle oder der Lamellen (2, 3) gebildet wird,
- Eliminieren (24) der ersten Schicht Siliziumoxid (15), um den Bereich (7) zwischen den beiden Lamellen (2, 3) zu vergrößern.

2. Herstellungsverfahren nach Anspruch 1, **dadurch gekennzeichnet, dass** es folgende Schritte umfasst:
- Wachsen lassen (25) einer zweite Schicht Siliziumoxid (17) auf der Oberfläche mindestens einer der am Rand des Bereichs (7) angeordneten Lamellen (2, 3), wobei die zweite Schicht Siliziumoxid (17) ausgehend von einer zweiten Siliziumunterschicht der Lamelle oder der Lamellen (2, 3) gebildet wird,
- Eliminieren (26) der zweiten Schicht Siliziumoxid (17), um den Bereich zwischen den beiden Lamellen (2, 3) noch weiter zu vergrößern.

3. Herstellungsverfahren nach Anspruch 1 oder 2, **dadurch gekennzeichnet, dass** die aufeinanderfolgenden Vergrößerungsschritte (23, 25) der Siliziumoxidschichten (15, 17) und der Eliminierung (24, 26) der Schicht (15, 17) wiederholt werden, um den Bereich (7) zwischen den beiden Lamellen (2, 3) zu vergrößern, um eine gewünschte Breite (D) zu erreichen.

4. Herstellungsverfahren gemäß irgendeinem der vorhergehenden Ansprüche, **dadurch gekennzeichnet, dass** das Rohwerk des Uhrwerks (1) gekreuzte Lamellen (2, 3) hat, die an der Kreuzung (4) durch eine Fuge (8) verbunden sind, wobei die Fuge (8) zumindest teilweise aus Siliziumdioxid besteht, wobei das Verfahren eine Phase des Eliminierens (22) des Siliziumdioxids aus der Fuge (8) zwischen den Lamellen (2, 3) umfasst, um diese zu trennen und den genannten Bereich (7) zwischen den Lamellen (2, 3) zu schaffen.

5. Herstellungsverfahren nach irgendeinem der vorhergehenden Ansprüche, **dadurch gekennzeichnet, dass** jede Siliziumdioxidschicht (13, 14, 15, 17) durch Ätzen mit gasförmigem Fluorwasserstoff eliminiert wird.

6. Herstellungsverfahren nach irgendeinem der vorhergehenden Ansprüche, **dadurch gekennzeichnet, dass** das Wachstum (23, 25) des Siliziumoxids durch feuchte oder trockene thermische Siliziumoxidation erfolgt.

7. Herstellungsverfahren nach irgendeinem der vorhergehenden Ansprüche, **dadurch gekennzeichnet, dass** das Rohwerk des Uhrwerks (1) durch ein profundes reaktives Ionenätzverfahren vom Typ DRIE geschaffen wird.

8. Herstellungsverfahren nach irgendeinem der vorstehenden Ansprüche, **dadurch gekennzeichnet, dass** jedes Wachstum (23, 25) und das Eliminieren (22, 24) der Siliziumoxidschicht (15, 17) das Eliminieren einer Unterschicht von mindestens 0,10 µm Dicke auf einer Lamelle (2, 3) ermöglicht, vorzugsweise von mindestens 0,40 µm.

9. Herstellungsverfahren nach irgendeinem der vorstehenden Ansprüche, **dadurch gekennzeichnet, dass** es eine zusätzliche Stufe (27) zum Wachstum einer zusätzlichen Oxidschicht auf dem Uhrwerk (1) umfasst, um die thermische Steifigkeit des Uhrwerks in Abhängigkeit von der Temperatur anzupassen, insbesondere um die Temperatur eines aus einer Pendelachse gebildeten Oszillators auszugleichen, und/oder um das Uhrwerk zu verstärken.

10. Herstellungsverfahren nach irgendeinem der vorhergehenden Ansprüche, **dadurch gekennzeichnet, dass** es einen Schritt (28) zur Bestimmung der ursprünglichen Steifigkeit der Achse (1) und zur Berechnung ihrer Abmessungen umfasst, um ein Uhrwerk (1) mit einer gewünschten Endsteifigkeit zu erhalten.

11. Herstellungsverfahren nach irgendeinem der vorhergehenden Ansprüche, **dadurch gekennzeichnet, dass** es einen zusätzlichen Schritt des Aufbringens einer elektrisch leitfähigen Schicht umfasst.

12. Herstellungsverfahren nach irgendeinem der vorhergehenden Ansprüche, **dadurch gekennzeichnet, dass** der Schritt der Bildung (21) des Rohwerks des Uhrwerks (1) die folgenden Unterschritte umfasst:
- Ausstatten mit einem SOl-Wafer (10), der nacheinander eine erste Siliziumschicht (11), eine Bindeschicht (13) aus Siliziumoxid und eine zweite Siliziumschicht (12) umfasst;
- Wachsen lassen einer Schicht aus Siliziumoxid (14) an der Oberfläche des Wafers (10);
- Ätzen der Schicht aus Siliziumoxid (14) auf einer ersten Seite des Wafers (10) durch eine Maske;
- Durchführen einer profunden reaktiven Ionenätzung, um mindestens eine erste Lamelle (2) des Uhrwerks (1) aus einteiligen flexiblen Siliziumlamellen zu bilden;
- Ätzen der Schicht aus Siliziumdioxid (14) auf einer zweiten Seite des Wafers (10) durch eine zuvor gebildete zweite Maske, die vorzugsweise relativ zu den auf der ersten Seite des Wafers gebildeten Mustern ausgerichtet ist,
- Durchführen einer profunden reaktiven Ionenätzung, um mindestens eine zweite Lamelle (3) des Uhrwerks (1) aus einteiligen flexiblen Siliziumlamellen zu bilden.

13. Herstellungsverfahren gemäß irgendeinem der vorhergehenden Ansprüche, **dadurch gekennzeichnet, dass** der minimale Bereich (7), der nach den Verfahrensschritten zwischen den Lamellen (2, 3) erhalten wird, eine Breite (D) von mehr als 10 µm, vorzugsweise mehr als 15 µm, aufweist.

## Claims

1. Method (20) for manufacturing a one-piece silicon watchmaking device (1) with flexible blades (2, 3), in particular for timepieces, for example a pivot with crossed blades, comprising the following steps of:
- forming (21) a one-piece silicon watchmaking device (1) blank from a wafer of the SOI type, the watchmaking device (1) comprising two flexible blades (2, 3), each formed in a different layer of the SOI wafer, the blades (2, 3) being arranged in two different substantially parallel planes, the blades (2, 3) being separated by a clearance (7), the method being **characterised in that** it also comprises the following steps of :
- growing (23) a first silicon oxide layer (15) on the surface of at least one of the blades (2, 3) bordering the clearance (7), the first silicon oxide layer (15) being formed from a first sub-layer of silicon of the one or more blades (2, 3),
- removing (24) the first silicon oxide layer (15) to increase the clearance (7) between the two blades (2, 3).

2. Manufacturing method according to claim 1, **characterised in that** it comprises the following steps of:
- growing (25) a second silicon oxide layer (17) on the surface of at least one of the blades (2, 3) bordering the clearance (7), the second silicon oxide layer (17) being formed from a second sub-layer of silicon of the one or more blades (2, 3),
- removing (26) the second silicon oxide layer (17) to further increase the clearance between the two blades (2, 3).

3. Manufacturing method according to claim 1 or 2, **characterised in that** the successive steps of growing (23, 25) silicon oxide layers (15, 17) and of removing (24, 26) the layer (15, 17) are repeated several times to increase the clearance (7) between the two blades (2, 3) in order to reach a desired width (D).

4. Manufacturing method according to any of the preceding claims, **characterised in that** the watchmaking device (1) blank comprises crossed blades (2, 3) joined at the crossover point (4) by a join (8), the join (8) being at least partially made of silicon oxide, the method comprising a step (22) of removing the silicon oxide from the join (8) between the blades (2, 3) to separate same by creating said clearance (7) between the blades (2, 3).

5. Manufacturing method according to any of the preceding claims, **characterised in that** each silicon oxide layer (13, 14, 15, 17) is removed by etching using hydrogen fluoride in the vapour phase.

6. Manufacturing method according to any of the preceding claims, **characterised in that** the silicon oxide is grown (23, 25) by wet or dry thermal oxidation of the silicon.

7. Manufacturing method according to any of the preceding claims, **characterised in that** the watchmaking device (1) blank is produced by deep reactive ion etching (DRIE).

8. Manufacturing method according to any of the preceding claims, **characterised in that** each growth (23, 25) and removal (22, 24) of a silicon oxide layer (15, 17) enables a sub-layer of silicon that is at least 0.10 µm thick, preferably at least 0.40 µm thick, to be eliminated from a blade (2, 3).

9. Manufacturing method according to any of the preceding claims, **characterised in that** it comprises an additional step (27) of growing an additional oxide layer on the watchmaking device (1) to thermally adjust the stiffness of the watchmaking device as a function of temperature, in particular to temperature-compensate an oscillator formed by a balance pivot assembly, and/or to reinforce the watchmaking device.

10. Manufacturing method according to any of the preceding claims, **characterised in that** it comprises a step (28) of determining the initial stiffness of the pivot (1) and of calculating the dimensions thereof to obtain a watchmaking device (1) of a desired final stiffness.

11. Manufacturing method according to any of the preceding claims, **characterised in that** it comprises an additional step of depositing an electrically conducting layer.

12. Manufacturing method according to any of the preceding claims, **characterised in that** the step (21) of forming the watchmaking device (1) blank comprises the following sub-steps of:
- procuring an SOI wafer (10) successively comprising a first silicon layer (11), a silicon oxide bonding layer (13), and a second silicon layer (12);
- growing a silicon oxide layer (14) on the surface of the wafer (10);
- etching the silicon oxide layer (14) on a first side of the wafer (10) through a mask;
- carrying out a deep reactive ion etching process to form at least a first blade (2) of the one-piece silicon watchmaking device (1) with flexible blades;
- etching the silicon oxide layer (14) on a second side of the wafer (10) through a second mask formed beforehand, preferably aligned with the patterns formed on the first side of the wafer;
- carrying out a deep reactive ion etching process to form at least a second blade (3) of the one-piece silicon watchmaking device (1) with flexible blades.

13. Manufacturing method according to any of the preceding claims, **characterised in that** the width (D) of the minimum clearance (7) obtained between the blades (2, 3) after the steps of the method is greater than 10 µm, preferably greater than 15 µm.
